# EUROPEAN PATENT APPLICATION

(11) **EP 2 312 561 A1**
(43) Date of publication of application: **20.04.2011**
(21) Application number: 09802869.9
(22) Date of filing: 22.07.2009
(51) Int. Cl.: G09F 9/30, H01L 27/32, H01L 51/50, H05B 33/02, H05B 33/10

(54) **DISPLAY DEVICE AND METHOD FOR MANUFACTURING DISPLAY DEVICE**

(30) Priority: 30.07.2008 JP 2008195773
(71) Applicant: Sumitomo Chemical Company, Limited, Tokyo 104-8260 (JP)
(72) Inventor: MATSUMURO, Tomonori, Tsukuba-shi Ibaraki 305-0051 (JP)
(74) Representative: Jackson, Martin Peter
(86) International application number: PCT/JP2009/063123
(87) International publication number: WO 2010/013626

(57) **Abstract**

A display device comprises: a metal substrate (301) having semiconductor elements (21, 22) and organic EL elements (24) provided thereon and connected to a power source; an interlayer insulating film (3) disposed between the metal substrate and the semiconductor elements (21, 22) and between the metal substrate and the organic EL elements and having contact holes (4a) formed therein; and contact hole wirings (4) that are formed in the contact holes and electrically connect the metal substrate to at least one of source electrodes (8a, 8d), drain electrodes (8b, 8c), and the anode electrodes (12) of the organic EL elements.

## Description

### TECHNICAL FIELD

The present invention relates to a display device comprising semiconductor elements and light-emitting elements driven by the semiconductor elements to emit light and to a method for manufacturing the display device.

### BACKGROUND ART

A display device is configured to comprise semiconductor elements and light-emitting elements driven by the semiconductor elements to emit light, and the emission of light from the light-emitting elements is controlled to display predetermined image information. Display devices that use, for example, organic electroluminescent (hereinafter referred to as EL) elements as light-emitting elements are being put to practical use (see, for example, Patent document 1). In such display devices that use organic EL elements, pixels are composed of the organic EL elements, transistors (semiconductor elements) for driving the organic EL elements, and the like.

### PRIOR ART DOCUMENT

### PATENT DOCUMENT

Patent document 1: JP 2005-346055 A

### DISCLOSURE OF INVENTION

### PROBLEM TO BE SOLVED BY THE INVENTION

Organic El elements are current-driven elements that emit light according to a current supplied from power source lines and are different from liquid crystal display elements, which are voltage-driven elements. Therefore, in display devices on which a large number of organic EL elements are integrated, a very large driving current must be applied to wirings such as power source lines that connect a power source to the organic EL elements. When the resistance values of the wirings through which the driving current flows are large, voltage drops are large, and therefore a high driving voltage must be used. This disadvantageously results in an increase in the consumption power of the display device. Conventionally, the electrodes of elements, wirings, and the like. that are connected to a power source are increased in width and also significantly increased in thickness so that the resistance values of current paths from the power source to the organic EL elements are reduced.

However, when the thicknesses of the wirings and electrodes are increased, the increased thicknesses cause large irregularities of the upper surface of a layer formed on the wirings, the electrodes, and the like. Therefore, in a top emission type organic EL element in which light is extracted from a side opposite to a substrate having transistor elements formed thereon, its light emission layer is generally formed on the upper surface of a layer having large irregularities formed thereon. The light emission layer of the top emission type organic EL element is formed, using a deposition technique such as a solution coating process or a vacuum deposition process, above the layers in which wirings, electrodes, and the like are formed. Therefore, in the conventional case, when the solution coating process is used as the film forming technique for organic EL elements, the influence of the irregularities is significantly larger than when the vacuum deposition process is used, so that the light-emitting layer of each of the organic EL elements is formed to have a non-uniform thickness even in a single pixel. When the thickness of the light-emitting layer is non-uniform, the light-emitting characteristics of each organic EL element vary largely even in a single pixel because of the influence of the thickness distribution. Therefore, the brightness of the light emitted from a single pixel at a constant driving current is non-uniform, and this undesirably results in deterioration of the performance of the display device.

The present invention has been made in view of the above problems, and it is an object of the invention to provide a display device in which voltage drops due to wiring resistance can be reduced, the flatness of each of elements for single pixels can be improved, and the variations in the light emission characteristics of each single pixel can be reduced. It is also an object of the invention to provide a method for manufacturing the display device.

### MEANS FOR SOLVING PROBLEM

For solving the above problem and achieving the above object, the present invention provides the following:
[1] A display device, comprising:
   a semiconductor element comprising a gate electrode, a source electrode, a drain electrode, and a semiconductor film formed between the source electrode and the drain electrode;
   a light-emitting element comprising electrodes and electrically connected to the semiconductor element;
   a metal substrate connected to a power source;
   an interlayer insulating film disposed between the metal substrate and the semiconductor element and between the metal substrate and the light-emitting element, the interlayer insulating film comprising a contact hole formed therein; and
   a contact hole wiring formed in the contact hole and electrically connecting the metal substrate and at least one of the source electrode, the drain electrode, and the electrodes of the light-emitting element.
[2] The display device according to above [1], wherein the semiconductor film is formed of an inorganic oxide semiconductor material.
[3] The display device according to above [1], wherein the semiconductor film is formed of an organic semiconductor material.
[4] The display device according to any one of above [1] to [3], wherein the light-emitting element is an organic electroluminescent element.
[5] A method for manufacturing a display device that comprises a semiconductor element including a gate electrode, a source electrode, a drain electrode, and a semiconductor film formed between the source electrode and the drain electrode, and a light-emitting element including electrodes and electrically connected to the semiconductor element, the method comprising:
   forming an interlayer insulating film on a metal substrate connected to a power source;
   forming a contact hole wiring that passes through the interlayer insulating film, the contact hole wiring being electrically connected at one end thereof to the metal substrate; and
   forming the source electrode, the drain electrode, and the electrodes of the light-emitting element on a side opposite to the substrate side with respect to the interlayer insulating film;
   wherein, in the step of forming the electrode, the source electrode, the drain electrode, and the electrodes of the light-emitting element are formed such that another end of the contact hole wiring is electrically connected to at least one of the source electrode, the drain electrode, and the electrodes of the light-emitting element.

### EFFECT OF THE INVENTION

In the present invention, a gate electrode, a source electrode, and a drain electrode are formed on a flat metal substrate connected to a power source, and the surface irregularities of a layer on which organic EL elements are formed can thereby reduced. Therefore, the non-uniformity of the thickness of the light-emitting layer of each organic EL element formed on that layer can be reduced. In this manner, the variations in the light-emission characteristics of the device as a whole and of each pixel can be reduced. Therefore, a display device having improved performance and a method for manufacturing the display device can be achieved.

### BRIEF DESCRIPTION OF DRAWINGS

[Fig. 1] Fig. 1 is a block diagram showing one example of an organic EL display device according to an embodiment of the present invention.
[Fig. 2] Fig. 2 is a circuit diagram of one pixel of the organic EL display device according to the embodiment of the present invention.
[Fig. 3] Fig. 3 is a cross-sectional view showing elements that constitute one pixel of the organic EL display device according to the embodiment of the present invention.
[Fig. 4-1] Fig. 4-1 is a layout diagram showing a substrate and wiring layers shown in Fig. 3.
[Fig. 4-2] Fig. 4-2 is a conceptual diagram showing schematic paths of current flows in the layout of the wiring layers shown in Fig. 4-1.
[Fig. 4-3] Fig. 4-3 is a schematic view showing the layer structure in a cross-section taken along A-A in Fig. 4-1.
[Fig. 5] Fig. 5 is a schematic view showing the wiring structure of driving signal lines in a conventional organic EL display device.
[Fig. 6] Fig. 6 is a cross-sectional view of a transistor for driving a pixel and an organic EL element in the conventional organic EL display device.
[Fig. 7-1] Fig. 7-1 is a cross-sectional view showing a method for manufacturing the pixel shown in Fig. 3.
[Fig. 7-2] Fig. 7-2 is a cross-sectional view showing the method for manufacturing the pixel shown in Fig. 3.
[Fig. 7-3] Fig. 7-3 is a cross-sectional view showing the method for manufacturing the pixel shown in Fig. 3.
[Fig. 7-4] Fig. 7-4 is a cross-sectional view showing the method for manufacturing the pixel shown in Fig. 3.
[Fig. 7-5] Fig. 7-5 is a cross-sectional view showing the method for manufacturing the pixel shown in Fig. 3.
[Fig. 7-6] Fig. 7-6 is a cross-sectional view showing the method for manufacturing the pixel shown in Fig. 3.
[Fig. 8] Fig. 8 is a cross-sectional view showing another example of elements that constitute one pixel of an organic EL display device according to an embodiment of the present invention.
[Fig. 9-1] Fig. 9-1 is a cross-sectional view showing a method for manufacturing the pixel shown in Fig. 8.
[Fig. 9-2] Fig. 9-2 is a cross-sectional view showing the method for manufacturing the pixel shown in Fig. 8.
[Fig. 9-3] Fig. 9-3 is a cross-sectional view showing the method for manufacturing the pixel shown in Fig. 8.
[Fig. 9-4] Fig. 9-4 is a cross-sectional view showing the method for manufacturing the pixel shown in Fig. 8.
[Fig. 9-5] Fig. 9-5 is a cross-sectional view showing the method for manufacturing the pixel shown in Fig. 8.

### BEST MODE(S) FOR CARRYING OUT THE INVENTION

Hereinafter, embodiments of the present invention will be described with reference to the drawings. However, the present invention is not limited to the embodiments. In the description of the drawings, the same parts are denoted by the same reference numerals. The drawings are only schematic, and it must be noted that the relationship between the thickness and width of each layer, the ratio between the layers, and the like are different from the actual values. The dimensional relationships and proportions are partially different from one drawing to another.

### (Embodiments)

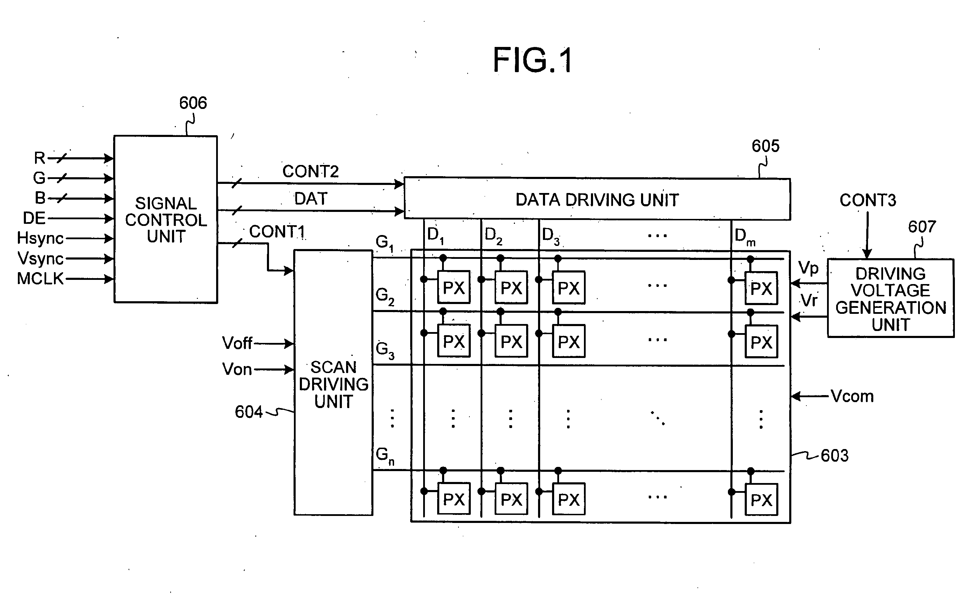

Embodiments of the present invention will be described. Fig. 1 is a block diagram illustrating one example of an organic EL display device according to the present embodiment. As shown in Fig. 1, the organic EL display device according to the present embodiment comprises a display panel 603, a scan driving unit 604, a data driving unit 605, a driving voltage generation unit 607 (these units are connected to the display panel 603), and a signal control unit 606 that controls these units. The display panel 603 is connected to a plurality of signal lines such as scan signal lines G₁, G₂, G₃,..., and Gₙ connected to the scan driving unit 604 to transmit scan signals Vg and data signal lines D₁, D₂, D₃,..., and Dₘ connected to the data driving unit 605 to transmit data signals Vd. The scan signal lines G₁ to Gₙ extend approximately in a row direction, and the data signal lines Di to Dₘ extend approximately in a column direction. The display panel 603 comprises a plurality of pixels PX that are arranged in an array and connected to the scan signal lines G₁ to Gₙ and the data signal lines D₁ to Dₘ, respectively.

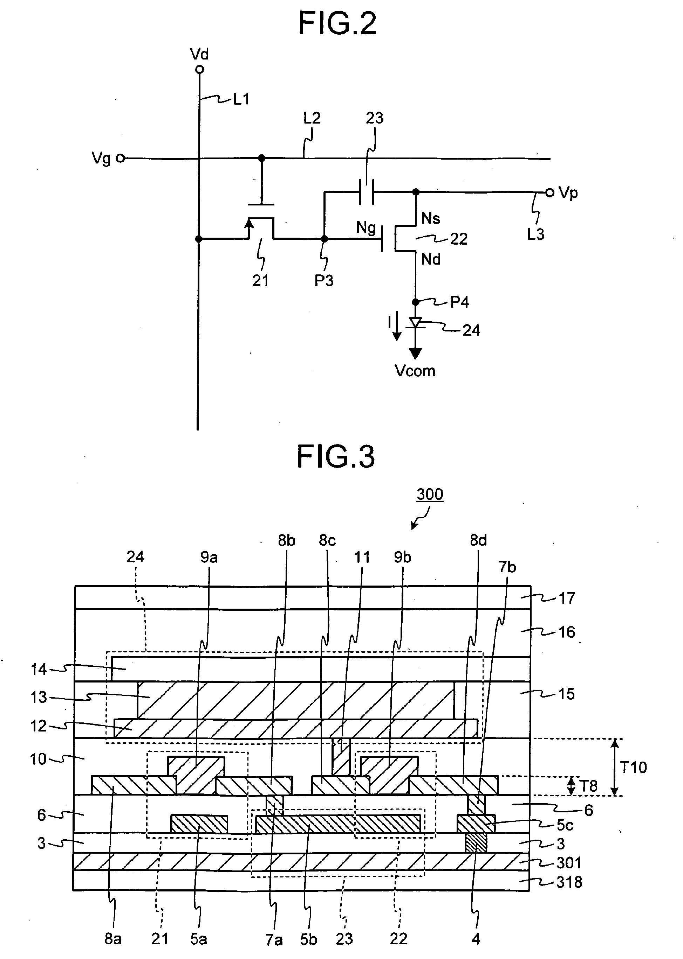

Fig. 2 is a circuit diagram of one pixel of the organic EL display device according to the present embodiment. As shown in Fig. 2, the display panel 603 further comprises a signal line L3 for transmitting a driving voltage signal Vp outputted from the driving voltage generation unit 607. The signal line L3 functions as a power source line for supplying a current. As shown in Fig. 2, each pixel comprises a switching transistor 21 and a driving transistor 22 serving as semiconductor elements, a capacitor 23, and an organic EL .element 24 serving as a light-emitting element. A signal line L1 shown in Fig. 2 is the data signal line for this pixel, and a signal line L2 is the scan signal line for this pixel.

The input terminal of the switching transistor 21 is connected to the signal line L1, the control terminal is connected to the signal line L2, and the output terminal is connected to the control terminal Ng of the driving transistor 22. The switching transistor 21 outputs the data signal Vd inputted to the data line of L1, to the driving transistor 22 in response to the scan signal Vg inputted to the scan signal line of the signal line L2.

The control terminal Ng of the driving transistor 22 is connected to the switching transistor 21, and the output terminal Nd is connected to the organic EL element 24. The input terminal Ns of the driving transistor 22 is connected to the signal line L3. The driving transistor 22 supplies the organic EL element 24 with an output current I having a magnitude controlled according to the magnitude of the voltage Vgs between the control terminal Ng and the input terminal Ns. The output current I is supplied from the signal line L3 functioning as a power source line through the input terminal Ns.

The capacitor 23 is provided between the control terminal Ng and the input terminal Ns of the driving transistor 22, charged by the data signal Vd applied to the control terminal Ng of the driving transistor 22, and holds the data signal Vd for a predetermined period.

The cathode electrode of the organic EL element 24 is connected to a common voltage Vcom, and the anode electrode is connected to the output terminal Nd of the driving transistor 22. The organic EL element 24 is driven by the driving transistor 22 and emits light according to the output current I.

Next, the structure of a pixel in the organic EL display device according to the present embodiment will be described. Fig. 3 is a cross-sectional view showing one pixel in the organic EL display device according to the present embodiment.

As shown in Fig. 3, the pixel 300 in the organic EL display device according to the present embodiment is configured to comprise the switching transistor 21, the driving transistor 22, the capacitor 23, and the organic EL element 24. This pixel 300 is formed on a metal substrate 301 that has high conductivity and functions as a power source line. A part of the metal substrate 301 may function as a part of the pixel 300.

The switching transistor 21 comprises: a gate electrode 5a that functions as the control terminal; a source electrode 8a that functions as the input terminal; a drain electrode 8b that functions as the output terminal; and a semiconductor film 9a that functions as a channel layer and is formed between the source electrode 8a and the drain electrode 8b so as to extend in contact with a part of the source electrode 8a and with a part of the drain electrode 8b and across them. The gate electrode 5a is connected to the signal line L2 at a region not shown in the drawings, and the source electrode 8a is connected to the signal line L1 at a region not shown in the drawings. A gate insulating film 6 is formed in a region between the gate electrode 5a, and the source electrode 8a, the drain electrode 8b and the semiconductor film 9a.

The driving transistor 22 comprises: a gate electrode 5b that functions as the control terminal Ng; a source electrode 8d that functions as the input terminal Ns; a drain electrode 8c that functions as the output terminal Nd; and a semiconductor film 9b that functions as a channel layer and is formed between the source electrode 8d and the drain electrode 8c so as to extend in contact with a part of the source electrode 8d and with a part of the drain electrode 8c and across them. The gate electrode 5b is connected to the drain electrode 8b of the switching transistor 21 through a contact hole wiring 7a. The gate insulating film 6 is formed in a region between the gate electrode 5b, and the source electrode 8d, the drain electrode 8c and the semiconductor film 9b. The contact hole wiring 7a is disposed in the gate insulating film 6 in the region between the gate electrodes 5a and 5b (the first gate electrode 5a and the second gate electrode 5b) and the source electrodes 8a and 8d (the first source electrode 8a and the second source electrode 8d) and the drain electrodes 8b and 8c (the first drain electrode 8b and the second drain electrode 8c). The contact hole wiring 7a corresponds to a point P3 in Fig. 2.

The organic EL element 24 comprises: an anode electrode 12 connected to the drain electrode 8c of the driving transistor 22 through a contact hole wiring 11; an organic film 13 formed on the anode electrode 12; and a cathode electrode 14 formed on the organic film 13. The organic film 13 is configured to comprise at least an organic light-emitting layer and emits light having a brightness according to the amount of current supplied from the anode electrode 12. If necessary, a hole injection layer, a hole transport layer, an electron transport layer, an electron injection layer, a hole block layer, and other layers may be provided between the anode electrode 12 and the cathode electrode 14. The contact hole wiring 11 is disposed in an interlayer insulating film 10 formed in a region between the source electrodes 8a and 8d, the drain electrodes 8b and 8c and the semiconductor film 9a and 9b, and the anode electrode 12 of the organic EL element 24. The interlayer insulating film 10 comprises, for example, a semiconductor protection film for protecting the semiconductor layers of the transistors and a planarization film formed for planarization. An interlayer film 15 is deposited between the interlayer insulating film 10 and the cathode electrode 14 and has an opening formed only in a region in which the organic EL element 24 is formed. The contact hole wiring 11 corresponds to a point P4 in Fig. 2.

The cathode electrode 14 is formed of a transparent.film or semi-transparent film. A protection film 16 formed of a transparent film or semi-transparent film and a transparent or semi-transparent upper substrate 17 are disposed on the cathode electrode 14. The light emitted from the organic film 13 passes successively through the cathode electrode 14, the protection film 16, and the upper substrate 17 and is outputted to the outside. Therefore, this organic EL element 24 is of a so-called top emission type.

In the present embodiment, the switching transistor 21 and the driving transistor 22 as the semiconductor elements and the organic EL element 24 as the light-emitting element are disposed on, for example, one main surface side of the metal substrate 301 (for example, the upper surface side) which is an element-forming surface side. The metal substrate 301 corresponds to the signal line L3 connected to the driving voltage generation unit 607 (see Fig. 1) that functions as a power source. More specifically, the metal substrate 301 functions as a power source line connected to the power source and supplies the organic EL element 24 through the driving transistor 22 with a current. An interlayer insulating film 3 having a contact hole formed therein is provided on the metal substrate 301. The metal substrate 301 is connected to the source electrode 8d of the driving transistor 22 through a contact hole wiring 4 formed in the contact hole in the interlayer insulating film 3, a connection film 5c that is formed immediately above the contact hole wiring 4 at the same layer level as the layer of the gate electrodes 5a and 5b, and a contact hole wiring 7b formed in the gate insulating film 6 and directly above the connection film 5c. The metal substrate 301 supplies the anode electrode 12 of the organic EL element 24 through the driving transistor 22 with a current. The capacitor 23 is formed of a part of the metal substrate 301, a part of the gate electrode 5b, and a part of the interlayer insulating film 3.

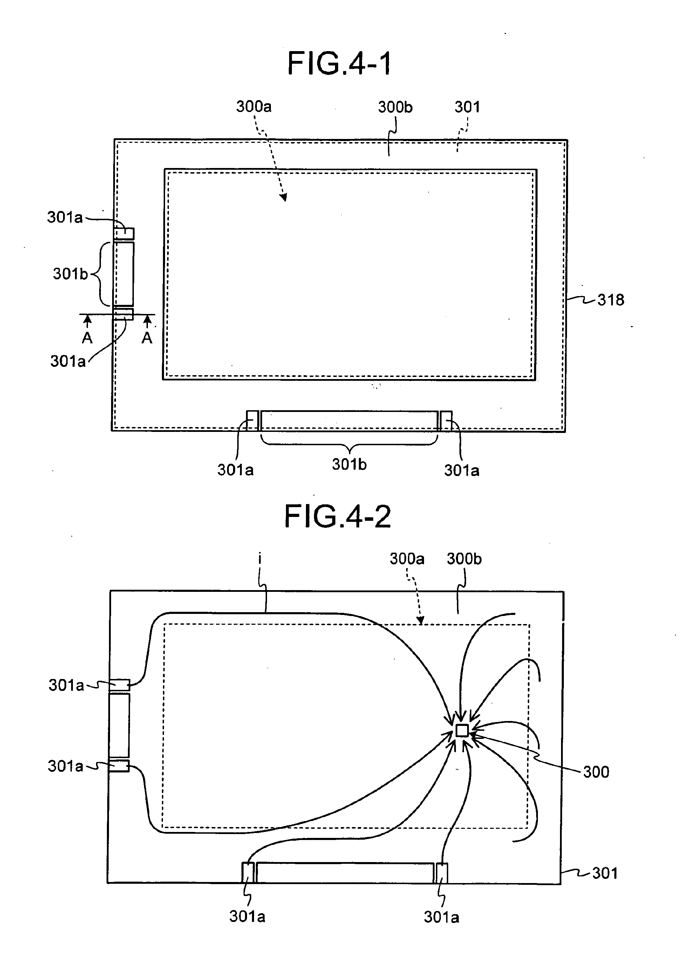

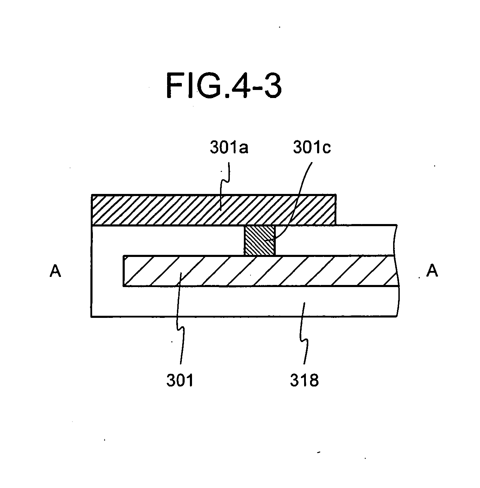

As shown in the layout diagram of Fig. 4-1, the metal substrate 301 is disposed such that a region 300a (referred to as a display region) in which the organic EL elements 24 are arranged in an array is superimposed on a region within the metal substrate 301 as viewed in its thickness direction. Therefore, in the metal substrate 301, an extending region 300b extending off the region on which the display region 300a is superimposed is present outside the superimposed region. As shown in Fig. 4-2, in the present embodiment, a current i flowing from power source terminals 301a provided at edge portions of the metal substrate 301 into the metal substrate 301 flows through the extending region 300b of the metal substrate 301 and then into each of the pixels 300 arranged in the display region 300a from all sides. As described above, the extending region 300b that is not superimposed on the display region 300a in the thickness direction of the metal substrate 301 functions as a main wiring portion of the power source line. Accordingly, in the present embodiment, voltage drops that occur in the metal substrate 301 constituting the power source line can thereby be suppressed. Therefore, the display quality of the organic EL display device can be improved, and a power source margin can be reduced. This allows a reduction in consumption power. As shown in Fig. 4-3, the metal substrate 301 is insulated and shielded by an insulating film 318 that is formed so as to cover areas around the four sides of the metal substrate 301 and also cover the surface opposite to the element forming surface. The power source terminals 301a for connecting the metal substrate 301 to the power source are disposed, for example, on the insulating film 318 covering the outer edges of the metal substrate 301, for example, together with other electrode terminals 301b. The metal substrate 301 is electrically connected to the power source terminals 301a through, for example, contact hole wirings 301c passing through the insulating film 318.

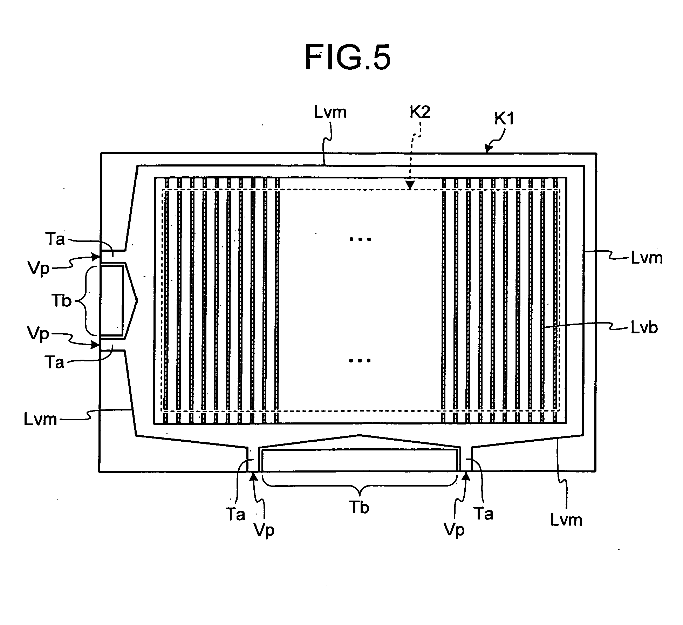

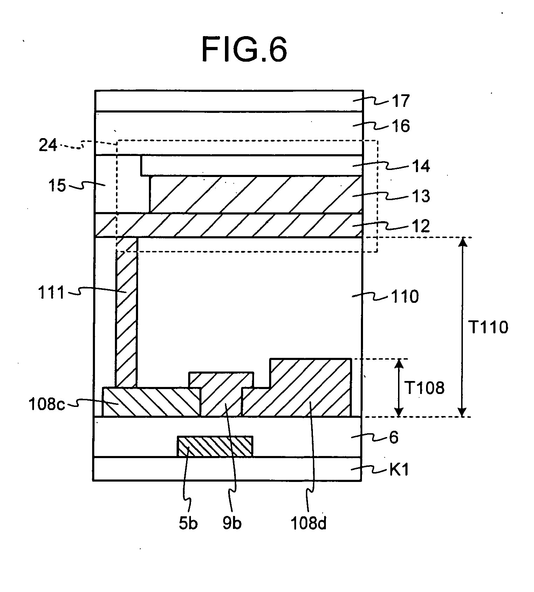

A description will now be given of the wiring structure of driving signal lines in a conventional organic EL display device. Fig. 5 is a schematic view showing the wiring structure of a driving signal line in the conventional organic EL display device, and Fig. 6 is a cross-sectional view of the driving transistor and organic EL element of a pixel in the conventional organic EL display device.

In the conventional organic EL display device, the driving signal lines are formed in the same layer as the layer for scan signal lines or data signal lines. As shown in Fig. 5, the driving signal lines comprise, for example: main wirings Lvm disposed in a frame shape so as to surround a display region K2 of a display panel 603 as viewed from the thickness direction of a substrate K1; and a plurality of branched wirings Lvb that are branched from row-directional main wirings Lvm and extend in a column direction to transmit a driving voltage signal to each pixel. Power source terminals Ta for electrically connecting the main wirings Lvm to a power source (not shown) may be disposed on, for example, at least one of the four sides that form the outer edges of the substrate K1 together with other electrode terminals Tb. In this layout of the conventional organic EL display device, the input terminals of the driving transistors of the pixels are connected to the branched wirings Lvb connected to the main wirings Lvm.

Organic EL elements are current-driven elements that emit light according to a current supplied from power source lines. Therefore, in a light-emitting device comprising a large number of organic EL elements integrated thereon, a very large current must be caused to flow through the power source lines for supplying the organic EL elements with the current. In view of the foregoing, it is desirable to increase the area of a power source line pattern to reduce the resistance of the branched wirings Lvb comprised in the power source lines. However, the space usable for the power line pattern is limited. Therefore, in the conventional device, to reduce the resistance of a power source line, at least part of a wiring connected to the power source line and at least part of a source electrode 108d of a driving transistor are increased in width and also largely increased in thickness, as shown in Fig. 6. More specifically, in the conventional structure, the thickness T108 of the source electrode 108d of the driving transistor is set to, for example, about 1 µm.

However, when the thicknesses of the wirings connected to the power source lines and the thickness of the source electrodes 108d of the driving transistors are increased, the increased thicknesses of the wirings and the electrodes cause large irregularities on layers above the wirings and the electrodes. The organic films comprised in the organic EL elements are applied to a layer having large irregularities caused by the increased thicknesses of the wirings and the electrodes. Therefore, the organic films of the organic EL elements are influenced by the irregularities of the undercoating film and have non-uniform coating thicknesses. This results in deterioration of characteristics caused by non-uniformity of brightness of emitted light and the like. Therefore, in the conventional structure, an interlayer insulating film 110 formed on the wirings and electrodes must be formed to have a very large thickness to absorb the irregularities caused by the increased thicknesses of the wirings and electrodes. More specifically, in the conventional structure, the interlayer insulating film 110 is formed to have a very large thickness T110 as large as 5 to 10 µm to absorb the irregularities. Also in the conventional structure, since the thickness of the interlayer insulating film 110 is very large, the depths of contact holes formed in the interlayer insulating film 110 are large. When the depths of the contact holes are small, contact hole wirings 111 can be formed together with anode electrodes 12 in the step of forming these electrodes. However, since the depths of the contact holes are large in the conventional structure, the step of burying a wiring material in the contact holes must be provided separately from the step of forming the anode electrodes 12, in order to form the contact hole wirings 111 that appropriately connect the drain electrodes 108c of the driving transistors to the anode electrodes 12 of the organic EL elements 24.

However, in the present embodiment, since the metal substrate 301 itself is used as a part of a wiring serving as the power source line, the area of the power source line pattern can be maximized as much as possible. Therefore, in the present embodiment, the resistance of the metal substrate 301 serving as a part of the power source line can be sufficiently reduced without increasing the thicknesses of the electrodes, and voltage drops can thereby be suppressed. This allows smooth supply of current to each organic EL element 24 even when the source electrode 8d is formed to have a smaller thickness T8 shown in Fig. 3 than the thickness T108.in the conventional structure (see Fig. 6). In the present embodiment, the thicknesses of the source and drain electrodes are about 30 nm to about 500 nm. The source and drain electrodes are formed of any of Cr, Au, Pt, Pd; APC (Ag-Pd-Cu), Mo, MoO₃, PEDOT, ITO (indium tin oxide), Ag, Cu, A1, Ti, Ni, Ir, Fe, W, MoW, alloys thereof, stacked films thereof, and the like. Mo and stacked films of Mo/Al/Mo and Ta/Cu/Ta are preferably used.

In the present embodiment, since the metal substrate 301 itself is used as a part of a wiring serving as the power source line, it is unnecessary to separately form a wiring layer used as the power source line. This allows a further reduction in the thickness of the display panel, and therefore the organic EL display device can be further reduced in thickness.

The upper surface being the element forming surface of the metal substrate 301 is flat. In addition, in the present embodiment, the source electrodes 8d can be formed to have a smaller thickness than that in the conventional structure, as described above. Therefore, in the present embodiment, even when the interlayer insulating film 10 is formed to have a smaller thickness T10 shown in Fig. 3 than the thickness T110 in the conventional structure (see Fig. 6), the upper surface of the interlayer insulating film 10 formed on the wirings and electrodes can have flatness comparable to or better than that in the conventional structure. Accordingly, in the present embodiment, the organic film 13 of each organic EL element 24 formed on the interlayer insulating film 10 can be formed to have a more uniform thickness. Therefore, in the present embodiment, the non-uniformity of the thickness of the formed organic film of each organic EL element 24 can be reduced, and more uniform brightness of the light emitted from each single pixel and also more uniform. brightness of the light emitted from the device as a whole can be achieved. Moreover, in the present embodiment, the thickness of the interlayer insulating film 10 is smaller than that in the conventional structure. Therefore, the contact holes provided in the interlayer insulating film 10 to form the contact hole wirings 11 can be accurately formed using a wet process, and connection failures between the drain electrodes 8c of the driving transistors 22 and the anode electrodes 12 of the organic EL elements 24 can be prevented. In addition, the metal substrate 301 can be suitably connected to the source electrodes 8d of the driving transistors 22 by providing, as necessary, contact hole wirings and a connection layer just like the contact hole wirings 4 formed in the interlayer insulating film 3, the connection films 5c, and the contact hole wirings 7b formed in the gate insulating film 6, between the metal substrate 301 and the source electrodes 8d of the driving transistors 22.

In the conventional structure, since the branched wirings Lvb branched from main wirings Lvm are formed into a line pattern shown in Fig. 5, voltage drops can occur due to wiring resistance. Therefore, in the conventional structure, the voltage applied to the organic EL element 24 in proportion to the consumption of current may largely fluctuate. To compensate fluctuations in brightness caused by the voltage fluctuations, a voltage corresponding to the fluctuations due to the voltage drops is added to the voltage applied to the main wirings Lvm as a power source voltage to compensate the drain-source voltage. Therefore, it is difficult to reduce the consumption power of the display device as a whole.

However, in the present embodiment, since the metal substrate 301 extending over the entire display panel 603 is used as the power source line that is connected to the power source, voltage drops are smaller than those in the conventional structure. Therefore, in the present embodiment, the voltage value added as the fluctuation component due to the voltage drops to the power source voltage can be made smaller than that in the conventional structure, and the consumption power of the display device as a whole can be reduced more than that in the conventional structure.

In the conventional structure, to prevent deterioration of the materials forming the pixels due to the heat generated in the display panel, an additional sheet member for heat diffusion is attached to the display panel to diffuse the heat generated in the display panel.

However, in the present embodiment, since the metal substrate 301 having high heat conductivity extends over the entire upper surface of the display panel, heat is diffused over the entire display panel through the metal substrate 301. A combination of the metal substrate 301 and a sheet member for heat diffusion is expected to provide a higher heat diffusion effect and a higher heat dissipation effect. Therefore, the deterioration of the materials forming the pixels can be suppressed, and the long-term reliability of the display device can be improved.

In the present embodiment, since the metal substrate 301 extending over the entire upper surface of the display panel is used as the power source line, the branched wirings Lvb themselves are not needed, and a wiring area for forming the branched wirings Lvb is not required to be provided. Accordingly, the aperture ratio can be increased by an amount corresponding to the wiring area. In the present embodiment, since the branched wirings Lvb themselves are not needed, higher definition can be achieved. Moreover, in the present embodiment, since one of the electrodes of the capacitor 23 is formed as a part of the metal substrate 301, the other electrode of the capacitor 23 can be formed on any region in the interlayer insulating film 3 on the metal substrate 301. Therefore, in the present embodiment, the region for forming the capacitor 23 can be flexibly selected.

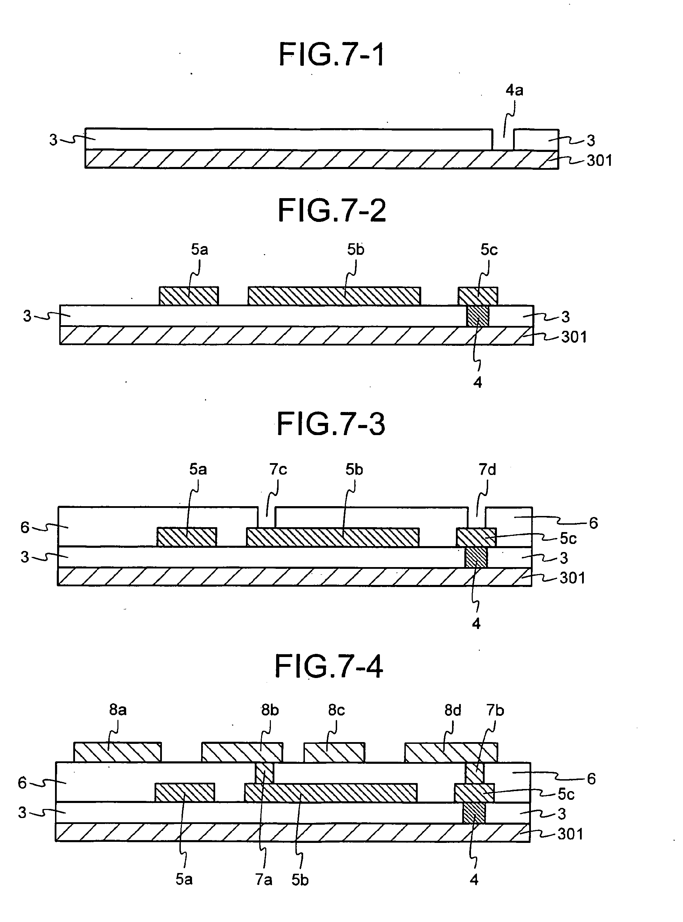

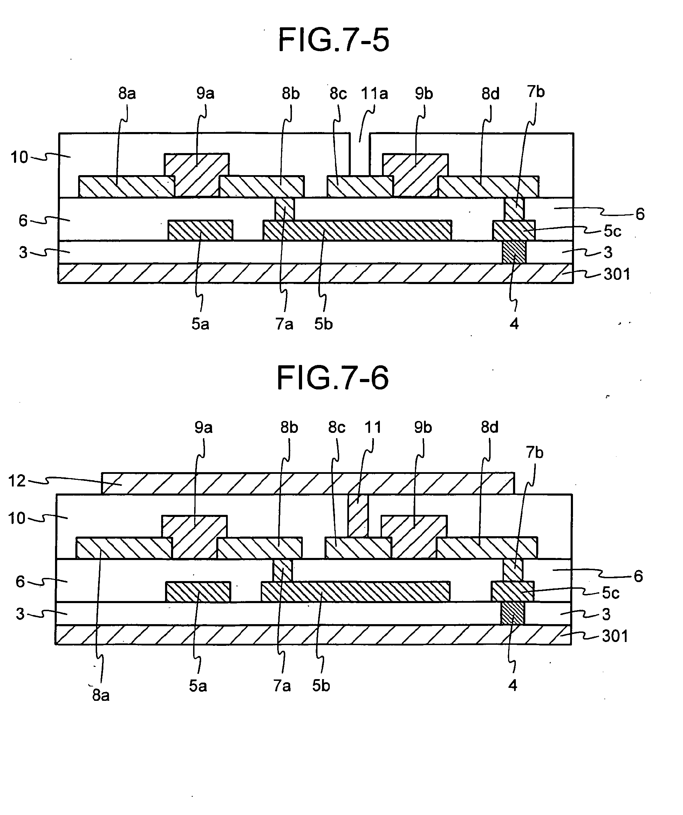

Next, a description will be given of a method for manufacturing the pixel 300 shown in Fig. 3. Figs. 7-1 to 7-6 are cross-sectional views showing the method for manufacturing the pixel 300 shown in Fig. 3. First, as shown in Fig. 7-1, the interlayer insulating film 3 having a thickness of about 500 nm to about 2 µm is formed on one main surface (which is referred to as an upper surface) of the metal substrate 301 that is perpendicular to the thickness direction thereof. Since the current supplied from the power source must be transmitted to the driving transistor 22 with a low resistance therebetween, a substrate formed of a high conductivity metal or an alloy thereof is used as the metal substrate 301. The interlayer insulating film 3 is formed of a material such as spin-on-glass (SOG), a photoresist, polyimide, SiNx, or SiO₂ and formed by spin coating method, sputtering method, CVD, or the like. Next, a contact hole 4a is formed in a position corresponding to the connection film 5c on the interlayer insulating film 3 using photolithography method (in the present specification, the "photolithography method" may comprise a patterning process such as an etching prosess). In the step of forming the contact hole 4a, it is preferable to form contact holes for the contact hole wirings 301c (see Fig. 4-3) that connect the metal substrate 301 to the power source terminals 301a at the edges of the substrate 301.

Then a conductive material is buried in the contact hole 4a to form the contact hole wiring 4. Next, to form the gate electrodes 5a and 5b and the connection film 5c, a metal material or a transparent conductive oxide material, for example, is deposited on the interlayer insulating film 3 and the contact hole wiring 4 using a vacuum deposition method, sputtering method, or coating method and then patterned into the gate electrodes 5a and 5b and the connection film 5c using photolithography method as shown in Fig. 7-2. The conductive material may not be buried in the contact hole 4a. In this case, a metal material or a transparent conductive oxide material, for example, is directly deposited in the contact hole 4a and on the entire formation regions of the gate electrodes 5a and 5b and the connection film 5c using any of the above methods and is then patterned by photolithography method to form the contact hole wiring 4, the gate electrodes 5a and 5b, and the connection film 5c at a time. The contact hole wiring 4, the gate electrodes 5a and 5b, and the connection film 5c may be formed using an ink-jet printing method, printing method, or the like. In the above step, it is preferable to form the contact hole wirings 301c (see Fig. 4-3) that connect the metal substrate 301 to the power source terminals 301a at the edges of the substrate 301.

Next, as shown in Fig. 7-3, the gate insulating film 6 is formed using a material such as an organic photosensitive resin. Desirably, the gate insulating film 6 is formed to have a dielectric constant of 1.5 or more and a thickness of 500 nm or less to ensure the driving ability of each transistor. The gate insulating film 6 is formed using a method, such as a coating method, suitable for the material. Then, contact holes 7c and 7d (a first contact hole 7c and a second contact hole 7d) are formed in the gate insulating film 6 using photolithography method, etching method, or the like.

Next, a conductive material is buried in the contact holes 7c and 7d to form the contact hole wirings 7a and 7b (the first contact hole wiring 7a and the second contact hole wiring 7b) shown in Fig. 7-4. Then to form the source electrodes 8a and 8d and the drain electrodes 8b and 8c, a metal material or a transparent conductive oxide material, for example, is deposited on the entire surface using a vacuum deposition method, sputtering method coating method, or the like and is then patterned into the source electrodes 8a and 8d and the drain electrodes 8b and 8c using photolithography method, etching method, or the like. The conductive material may not be buried in the contact holes 7c and 7d. In this case, a metal material or a transparent conductive oxide material, for example, is directly deposited in the contact holes 7c and 7d and on the entire formation regions of the source electrodes 8a and 8d and the drain electrodes 8b and 8c using any of the above methods and may be then patterned by photolithography method to form the contact hole wirings 7a and 7b, the source electrodes 8a and 8d, and the drain electrodes 8b and 8c at a time. The contact hole wirings 7a and 7b, the source electrodes 8a and 8d, and the drain electrodes 8b and 8c may be formed using an ink-jet printing method, printing method, or the like.

Next, as shown in Fig. 7-5, the semiconductor films 9a and 9b (the first semiconductor film 9a and the second semiconductor film 9b) are formed between the source electrode 8a and the drain electrode 8b and between the source electrode 8d and the drain electrode 8c, respectively. The semiconductor films 9a and 9b are formed of an inorganic oxide semiconductor material such as ZTO, an organic semiconductor material comprising a precursor of pentacene or tetrabenzoporphyrin, or an inorganic semiconductor material such as amorphous silicon or polysilicon. The semiconductor films 9a and 9b are formed by a method, such as a vacuum deposition method, sputtering method, coating method, or CVD method, suitable for the material and are then patterned using photolithography method. The semiconductor films 9a and 9b may be formed using an ink-jet printing method, printing method, or the like. Next, a protection film (not shown) is formed on the semiconductor films 9a and 9b, and then the interlayer insulating film 10 having a planarizing function is formed to absorb the irregularities of the source electrodes 8a and 8d, the drain electrodes 8b and 8c, and the semiconductor films 9a and 9b. The interlayer insulating film 10 is formed of, for example, a photosensitive resin and has a thickness of about 2 µm to about 10 µm. Next, a contact hole 11a is formed in the interlayer insulating film 10 by photolithography method. Preferably, the protection film (not shown) has a dielectric constant of 3.5 or less to prevent a back channel formed by an electrical coupling between the protection film and an electrode thereabove. In addition, it is necessary that the protection film have no influence on the semiconductor characteristics.

Next, as shown in Fig. 7-6, a conductive material is buried in the contact hole 11a to form the contact hole wiring 11. Then, to form the anode electrode 12 of the organic EL element 24, a film of, for example, a metal material or a transparent conductive oxide material is deposited on the entire surface using a vacuum deposition, sputtering, or similar method and is then patterned into the anode electrode 12 using photolithography, etching, or a similar method. The anode electrode 12 is formed of, for example, a stacked film of ITO/Ag/ITO or ITO/A1/ITO. The conductive material may not be buried in the contact hole 11a. In this case, a film of, for example, a metal material or a transparent conductive oxide material is directly formed in the contact hole 11a and on the entire formation region of the anode electrode 12 using any of the above methods and may be then patterned by photolithography method to form the contact hole wiring 11 and the anode electrode 12 at a time.

Next, the organic film of the organic EL element 24 is formed on the anode electrode 12, and then the cathode electrode 14 is formed using a transparent or semi-transparent metal material or conductive oxide material. The cathode electrode 14 is formed of, for example, an alloy material of Mg and Ag. Then the transparent or semi-transparent protection film 16 for protecting the organic EL element 24 is formed, and the upper substrate 17 is disposed on the protection film 16. The pixel 300 shown in Fig. 3 is thereby obtained. The step of forming the insulating film 318 that covers the rear surface of the metal substrate 301 and areas around the four sides thereof, the step of forming the power source terminals 301a for connecting the metal substrate 301 to the power source, and the step of forming the electrode terminals 301b for connecting various wirings to the outside are appropriately performed before, after, or between any of the above steps.

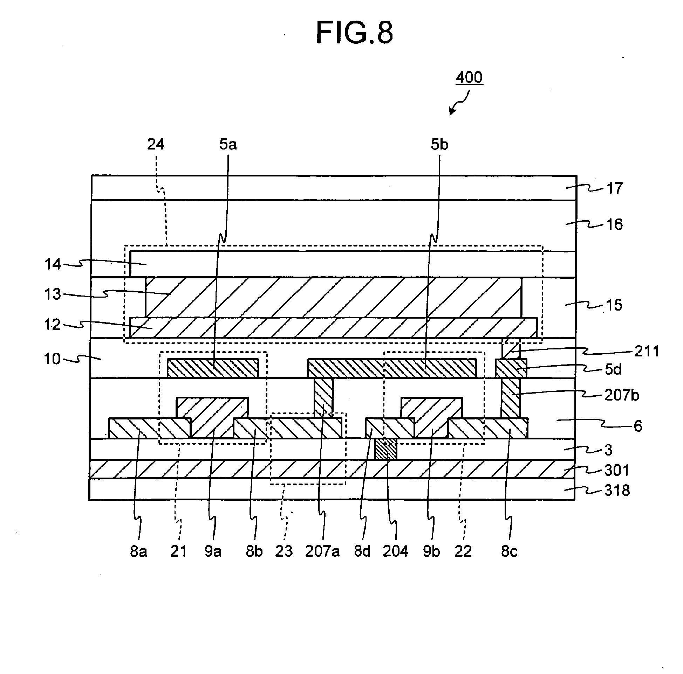

The pixel 300 having a bottom gate structure in which the gate electrode is formed below the source and drain electrodes and close to the substrate as shown in Fig. 3 has been described as a pixel structure in the present embodiment. Of course, a pixel 400 having a top gate structure in which gate electrodes 5a and 5b are formed above source electrodes 8a and 8d and drain electrodes 8b and 8c and close to an organic EL element 24 as shown in Fig. 8 may be used.

As in the pixel 300, the pixel 400 comprises: a switching transistor 21 comprising a gate electrode 5a, a source electrode 8a, a drain electrode 8b, and a semiconductor film 9a; a driving transistor 22 comprising a gate electrode 5b, a source electrode 8d, a drain electrode 8c, and a semiconductor film 9b; and an organic EL element 24 comprising an anode electrode 12, an organic film 13, and a cathode electrode 14, as shown in Fig. 8. A gate insulating film 6 is formed in a region between the source electrodes 8a and 8d, the drain electrodes 8b and 8c and the semiconductor films 9a and 9b, and the gate electrodes 5a and 5b. An interlayer insulating film 10 for absorbing the irregularities of the electrodes is formed on the gate electrodes 5a and 5b. As described above, the pixel 400 has a top gate structure in which the gate electrodes 5a and 5b are formed above the source electrodes 8a and 8d and the drain electrodes 8b and 8c and closer to the organic EL element 24.

In the pixel 400, as in the pixel 300, a substrate on which the switching transistor 21, the driving transistor 22, and the organic EL element 24 are formed is a metal substrate 301 that functions as a power source line. The metal substrate 301 is connected to the source electrode 8d of the driving transistor 22 through a contact hole wiring 204 formed in an interlayer insulating film 3. The drain electrode 8c of the driving transistor 22 is connected to the anode electrode 12 of the organic EL element 24 through a contact hole wiring 207b formed in the gate insulating film 6, a connection film 5d that is formed immediately above the contact hole wiring 207b at the same layer level as the layer of the gate electrodes 5a and 5b, and a contact hole wiring 211 formed in the interlayer insulating film 10 and immediately above the connection film 5d. The gate electrode 5b of the driving transistor 22 is connected to the drain electrode 8b of the switching transistor 21 through a contact hole wiring 207a formed in the gate insulating film 6. A capacitor 23 is formed of a part of the metal substrate 301, a part of the drain electrode 8b, and a part of the interlayer insulating film 3.

As described above, also in the pixel 400 having the top gate structure, a current is supplied to the organic EL element 24 using the metal substrate 301 extending over the entire display panel 603. In this manner, the resistance of the metal substrate 301 that functions as the power source line can be sufficiently reduced without increasing the thicknesses of the electrodes, and large irregularities caused by the metal substrate 301 are not formed on the surface of the interlayer insulating film 10, so that the organic film 13 formed can have a more uniform thickness. Therefore, the same effects as those of the pixel 300 can be obtained. More specifically, uniform brightness of the light emitted from each single pixel and also uniform brightness of the light emitted from the device as a whole can be achieved, and a reduction in consumption power and prevention of heat concentration can also be achieved.

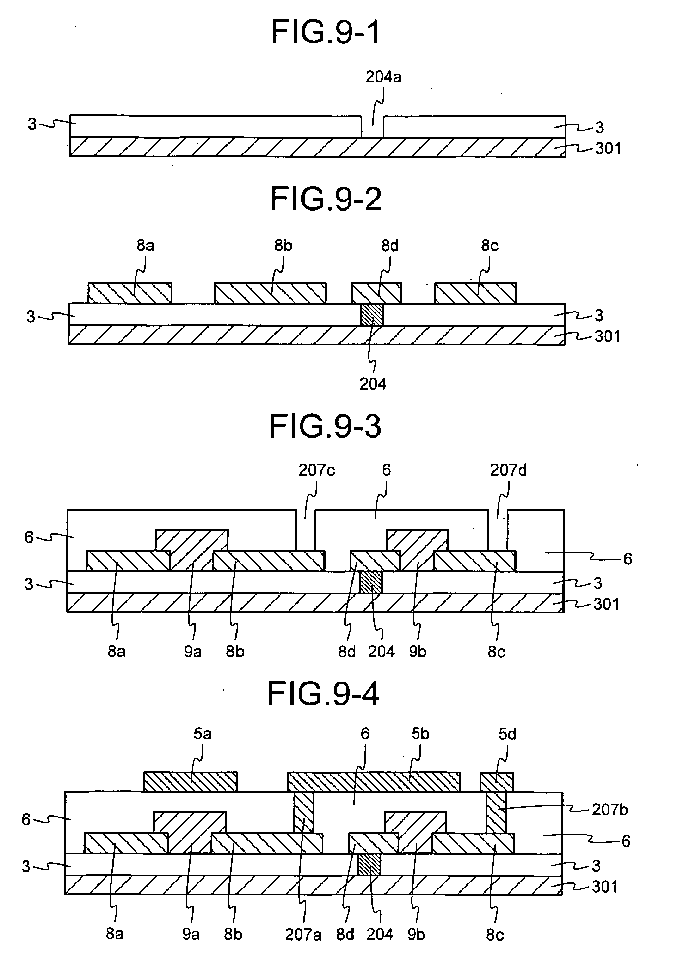

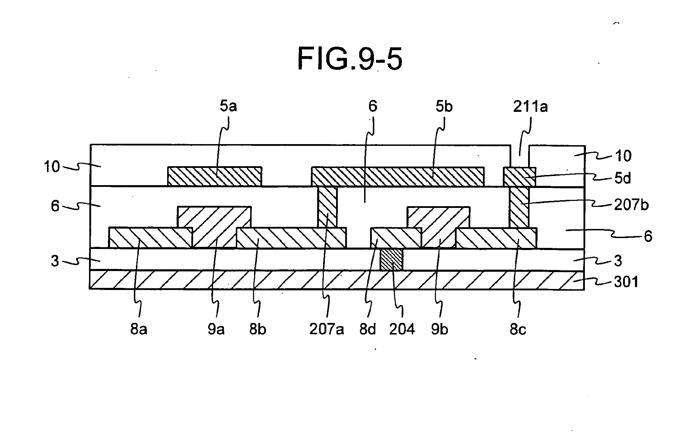

Next, a description will be given of a method for manufacturing the pixel 400 shown in Fig. 8. Figs. 9-1 to 9-5 are cross-sectional views showing the method for manufacturing the pixel 400 shown in Fig. 8. First, as shown in Fig. 9-1, the interlayer insulating film 3 is formed on the metal substrate 301 in the same manner as in Fig. 7-1. Next, a contact hole 204a is formed in the interlayer insulating film 3 in a position corresponding to the source electrode 8d by photolithography method. Then as shown in Fig. 9-2, a conductive material is buried in the contact hole 204a to form the contact hole wiring 204. Then, to form the source electrodes 8a and 8d and the drain electrodes 8b and 8c, a metal material or a transparent conductive oxide material, for example, is deposited using a vacuum deposition method, sputtering method, coating method, or the like and is then patterned into the source electrodes 8a and 8d and the drain electrodes 8b and 8c using photolithography method, etching method, or the like, as in the case of the pixel 300. The contact hole wiring 204, the source electrodes 8a and 8d, and the drain electrodes 8b and 8c may be formed at a time.

Next, as in the case of the pixel 300, the semiconductor films 9a and 9b are formed between the source electrode 8a and the drain electrode 8b and between the source electrode 8d and the drain electrode 8c, respectively, as shown in Fig. 9-3, and the gate insulating film 6 is formed in the same manner as in Fig. 7-3. Then contact holes 207c and 207d are formed in the gate insulating film 6, and a conductive material is buried in the contact holes 207c and 207d to form the contact hole wirings 207a and 207b, as shown in Fig. 9-4. Next, as in the case of the pixel 300, to form the gate electrodes 5a and 5b and the connection film 5d, a metal material or a transparent conductive oxide material, for example, is deposited on the gate insulating film 6 and the contact hole wirings 207a and 207b using a vacuum deposition method, sputtering method, or coating method and is then patterned into the gate electrodes 5a and 5b and the connection film 5d using photolithography method, as shown in Fig. 9-4.
The contact hole wirings 207a and 207b, the gate electrodes 5a and 5b, and the connection film 5d may be formed at a time.

Next, as in the case of the pixel 300, the interlayer insulating film 10 for absorbing the irregularities of the film therebelow is formed as shown in Fig. 9-5, and then a contact hole 211a is formed in the interlayer insulating film 10. Next, as in the case of the pixel 300, a conductive material is buried in the contact hole 211a to form the contact hole wiring 211, and the anode electrode 12 of the organic EL element 24 is formed. Then the organic film of the organic EL element is formed on the anode electrode 12 by applying. Next, as in the case of the pixel 300, the cathode electrode 14 is formed, and a protection film 16 for protecting the organic EL element 24 is formed. Then an upper substrate 17 is disposed on the protection film 16, and the pixel 400 shown in Fig. 8 is thereby obtained.

In the above embodiments, the pixels 300 and 400 of the so-called top emission type have been described as examples, but the invention is not limited thereto. The invention is, of course, applicable to pixels having a so-called bottom emission type structure. When the bottom emission type is used, the electrodes of the transistors are formed as transparent electrodes, and a substrate formed of a transparent conductive material is used instead of the metal substrate 301.

### EXPLANATIONS OF LETTERS OR NUMERALS

3 interlayer insulating film
4, 7a, 7b, 11, 111, 204, 207a, 207b, 211 contact hole wiring
4a, 7c, 7d, 11a, 204a, 207c, 207d, 211a contact hole 5a, 5b gate electrode
5c, 5d connection film
6 gate insulating film
8a, 8d, 108d source electrode
8b, 8c, 108c drain electrode
9a, 9b semiconductor film
10, 110 interlayer insulating film
12 anode electrode
13 organic film
14 cathode electrode
16 protection film
17 upper substrate
21 switching transistor
22 driving transistor
23 capacitor
24 organic EL element
300, 400 pixel
300a display region
300b extending region
301 metal substrate
318 insulating film
603 display panel
604 scan driving unit
605 data driving unit
606 signal control unit
607 driving voltage generation unit

## Claims

1. A display device, comprising:
a semiconductor element comprising a gate electrode, a source electrode, a drain electrode, and a semiconductor film formed between the source electrode and the drain electrode;
a light-emitting element comprising electrodes and electrically connected to the semiconductor element;
a metal substrate connected to a power source;
an interlayer insulating film disposed between the metal substrate and the semiconductor element and between the metal substrate and the light-emitting element, the interlayer insulating film comprising a contact hole formed therein; and
a contact hole wiring formed in the contact hole and electrically connecting the metal substrate and at least one of the source electrode, the drain electrode, and the electrodes of the light-emitting element.

2. The display device according to claim 1, wherein the semiconductor film is formed of an inorganic oxide semiconductor material.

3. The display device according to claim 1, wherein the semiconductor film is formed of an organic semiconductor material.

4. The display device according to claim 1, wherein the light-emitting element is an organic electroluminescent element.

5. A method for manufacturing a display device that comprises a semiconductor element including a gate electrode, a source electrode, a drain electrode, and a semiconductor film formed between the source electrode and the drain electrode, and a light-emitting element including electrodes and electrically connected to the semiconductor element,
the method comprising:
forming an interlayer insulating film on a metal substrate connected to a power source;
forming a contact hole wiring that passes through the interlayer insulating film, the contact hole wiring being electrically connected at one end thereof to the metal substrate; and
forming the source electrode, the drain electrode, and the electrodes of the light-emitting element on a side opposite to the substrate side with respect to the interlayer insulating film;
wherein, in the step of forming the electrode, the source electrode, the drain electrode, and the electrodes of the light-emitting element are formed such that another end of the contact hole wiring is electrically connected to at least one of the source electrode, the drain electrode, and the electrodes of the light-emitting element.
